# NEW EUROPEAN PATENT SPECIFICATION

(11) **EP 2 322 322 B2**
(45) Date of publication and mention of the opposition decision: **05.10.2022**
(45) Mention of the grant of the patent: 13.03.2013
(21) Application number: 09762550.3
(22) Date of filing: 12.06.2009
(51) Int. Cl.: C09K 3/14, B24D 3/00, C01F 7/44, C01F 7/02

(54) **ALUMINUM OXIDE PARTICLE AND POLISHING COMPOSITION CONTAINING THE SAME**
ALUMINIUMOXIDPARTIKEL UND DIESEN ENTHALTENDE POLIERZUSAMMENSETZUNG
PARTICULE D'OXYDE D'ALUMINIUM ET COMPOSITION DE POLISSAGE COMPRENANT CELLE-CI

(30) Priority: 13.06.2008 JP 2008155603
(43) Date of publication of application: 18.05.2011
(73) Proprietor: FUJIMI INCORPORATED, Kiyosu-shi Aichi 452-8502 (JP)
(72) Inventor: MORINAGA, Hitoshi, Kiyosu-shi Aichi 452-8502 (JP); TAHARA, Muneaki, Kiyosu-shi Aichi 452-8502 (JP); MATSUNAMI, Yasushi, Kiyosu-shi Aichi 452-8502 (JP)
(74) Representative: Neuefeind, Regina
(86) International application number: PCT/JP2009/060766
(87) International publication number: WO 2009/151120

(56) References cited:
- EP-A1- 0 563 653
- JP-A- H05 271 647
- JP-A- 2000 038 573
- JP-A- 2001 035 818
- JP-A- 2002 219 646
- JP-A- 2006 214 076
- JP-A- 2006 229 037
- JP-A- 2007 092 064
- JP-A- 2007 250 147
- JP-A- 2008 012 668
- US-A1- 2007 084 134

## Description

### TECHNICAL FIELD

The present invention relates to aluminum oxide particles composed of an aluminum oxide including alumina such as α-alumina and a transition alumina, and a hydrated alumina such as boehmite, and to a polishing composition containing the same.

### BACKGROUND ART

Aluminum oxide particles are used, for example, as abrasive grains in the applications of polishing substrates for use in electronic components such as semiconductor device substrates, display substrates, hard disk substrates, and sapphire substrates for LED. Since these substrates are required to have high smoothness and low defects, the aluminum oxide particles to be used have a relatively small particle size (for example, see Patent Documents 1 and 2). Generally, a polishing composition containing aluminum oxide particles as loose abrasive grains has a high polishing rate (removal rate) of a substrate compared with a polishing composition containing colloidal silica as loose abrasive grains. However, even in the case of a polishing composition containing aluminum oxide particles, the polishing rate of a substrate by the polishing composition generally decreases as the particle size of the aluminum oxide particles decreases. Furthermore, with the decrease in the particle size of aluminum oxide particles, it becomes difficult to remove, by cleaning, the aluminum oxide particles adhering to the substrate surface after polishing (that is, the ease of washing off of the aluminum oxide particles decreases).

### PRIOR ART DOCUMENTS

Patent Document 1: Japanese Laid-Open Patent Publication No. 3-277683
Patent Document 2: Japanese Laid-Open Patent Publication No. 5-271647

### SUMMARY OF INVENTION

### Problems that the Invention is to Solve

Accordingly, it is an object of the present invention to provide aluminum oxide particles that can be suitably used as abrasive grains without causing adverse effects such as reduction in the polishing rate and reduction in the ease of washing off even if the particle size is small, and to provide a polishing composition containing the aluminum oxide particles.

### Means for Solving the Problems

In order to achieve the object as described above, and in accordance with one aspect of the present invention, aluminum oxide particles are provided that include primary particles each having a hexahedral shape and an aspect ratio of 1 to less than 3 as defined in claim 1. The aluminum oxide particles preferably have an average primary particle size of 0.01 to 0.6 µm. The aluminum oxide particles preferably have an alpha conversion rate of 5 to 70%. Further, the aluminum oxide particles preferably have an average secondary particle size of 0.01 to 2 µm, and the value obtained by dividing the 90% particle size of the aluminum oxide particles by the 10% particle size of the aluminum oxide particles is preferably 3 or less.

In accordance with another aspect of the present invention, a polishing composition is provided that contains the aluminum oxide particles as described above and water.

### Effects of the Invention

According to the present invention, aluminum oxide particles are provided that can be suitably used as abrasive grains without causing adverse effects such as reduction in the polishing rate and reduction in the ease of washing off even if the particle size is small, and also a polishing composition is provided that contains the aluminum oxide particles.

### BRIEF DESCRIPTION OF THE DRAWINGS

Fig. 1 shows a scanning electron micrograph of an example of the aluminum oxide particles according to one embodiment of the present invention; and
Fig. 2 shows two scanning electron micrographs of another example of the aluminum oxide particles according to the same embodiment.

### MODE FOR CARRYING OUT THE INVENTION

Hereinafter, one embodiment of the present invention will be described.

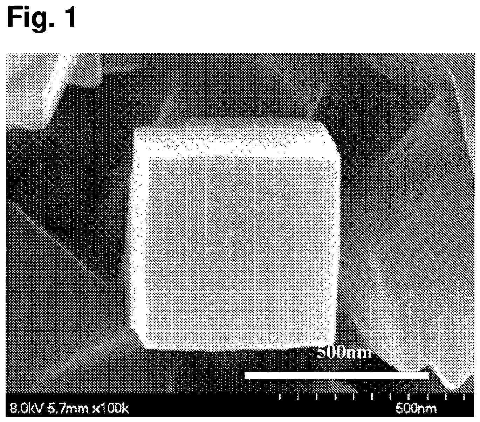

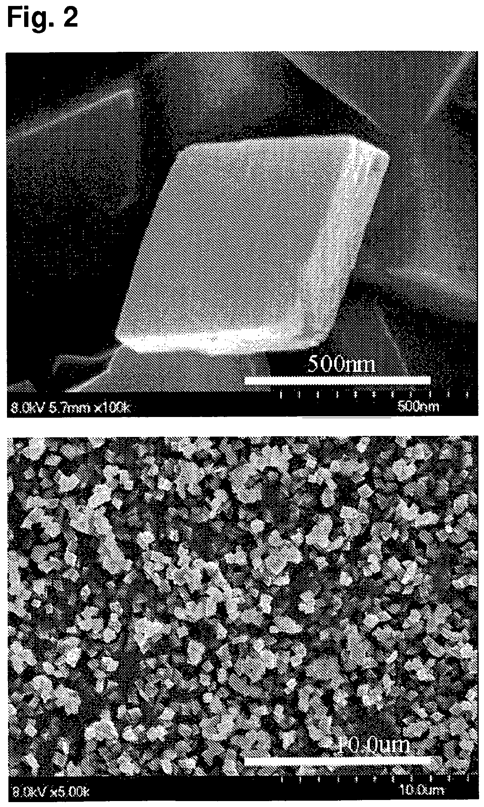

Aluminum oxide particles according to the present embodiment include primary particles each having a hexahedral shape. The primary particles of aluminum oxide preferably each have a contour shape close to a parallelepiped defined by two opposing squares and four rectangles or squares, or a parallelepiped defined by two opposing rhombuses and four rectangles or squares. Fig. 1 shows the example of the former, and Fig. 2 shows the example of the latter.

The aluminum oxide primary particles have an aspect ratio in the range of 1 to less than 3. Here, the aspect ratio is defined as "a" divided by "c", wherein "a" represents the length of the longest edge, and "c" represents the length of the shortest edge, among the three edges extending from one vertex of an aluminum oxide primary particle having a hexahedral shape. The length "b" of the remaining one edge is preferably substantially equal to the length "a" of the longest edge. Aluminum oxide particles of the present embodiment have an advantage that they can be suitably used as abrasive grains without causing adverse effects such as reduction in the polishing rate and reduction in the ease of washing off even if the particle size is small, because they include primary particles having an aspect ratio in the range as described above. In order to further improve the advantage of the aluminum oxide particles, the aspect ratio of the primary particles is preferably as small as possible. Specifically, the aluminum oxide primary particles have preferably an aspect ratio of 2 or less, further preferably 1.5 or less.

Aluminum oxide particles of the present embodiment are used, for example, as abrasive grains in the applications of polishing an object to be polished formed of a metal (including a simple metal such as copper, aluminum, tungsten, platinum, palladium, and ruthenium, and a metal alloy such as nickel-phosphorus), a semiconductor (including an elemental semiconductor such as germanium and silicon, a compound semiconductor such as germanium silicide, gallium arsenide, indium phosphide, and gallium nitride, and an oxide semiconductor such as sapphire), and an insulating material (including a glass such as aluminosilicate glass and a plastic such as a urethane resin, an acrylic resin, and a polycarbonate resin). More specifically, the aluminum oxide particles are used, for example, in the polishing of the wiring of semiconductor device substrates formed of a base metal such as aluminum and copper and a noble metal such as platinum, palladium, and ruthenium; in the polishing of the surface of nickel-phosphorus plated hard disk substrates; in the polishing of glass disk substrates; in the polishing of plastic lenses for glasses; in the polishing of color filter substrates for liquid crystal displays; and in the polishing of sapphire substrates for LED. The aluminum oxide particles may be used as loose abrasive grains or may be used as fixed abrasive grains.

When aluminum oxide particles of the present embodiment are used as abrasive grains, they have suitable ranges to be described below with respect to the average primary particle size, the average secondary particle size, the particle size distribution, and the alpha conversion rate.

### With respect to the average primary particle size

The aluminum oxide particles preferably have an average primary particle size of 0.01 µm or more, more preferably 0.03 µm or more, further preferably 0.05 µm or more. Here, the average primary particle size is defined as the average value of the length of the longest edge among the three edges extending from one vertex of each aluminum oxide primary particle having a hexahedral shape. The polishing rate (removal rate) of an object to be polished with aluminum oxide particles increases with the increase in the average primary particle size of the aluminum oxide particles. In this regard, when the aluminum oxide particles have an average primary particle size of 0.01 µm or more, or more specifically 0.03 µm or more, or 0.05 µm or more, it will be easier to increase the polishing rate to a particularly suitable level for practical use.

Furthermore, the aluminum oxide particles preferably have an average primary particle size of 0.6 µm or less, more preferably 0.35 µm or less, and further preferably 0.25 µm or less. The number of scratches and the surface roughness of an object to be polished after polishing with aluminum oxide particles decrease with the decrease in the average primary particle size of the aluminum oxide particles. In this regard, when the aluminum oxide particles have an average primary particle size of 0.6 µm or less, or more specifically 0.35 µm or less, or 0.25 µm or less, it will be easier to reduce the number of scratches and the surface roughness to a particularly suitable level for practical use.

### With respect to the average secondary particle size

The aluminum oxide particles preferably have an average secondary particle size of 0.01 µm or more, more preferably 0.03 µm or more, further preferably 0.05 µm or more. Here, the average secondary particle size is equal to the particle size of the aluminum oxide particle that is lastly summed up when the volume of the aluminum oxide particles is accumulated from particles of the smallest size in ascending order of the particle size measured by a laser scattering method until the accumulated volume reaches 50% or more of the total volume of all the aluminum oxide particles. The polishing rate of an object to be polished with aluminum oxide particles increases with the increase in the average secondary particle size of the aluminum oxide particles. Furthermore, with the increase in the average secondary particle size of the aluminum oxide particles, it will be easier to remove, by cleaning, the aluminum oxide particles adhering to the surface of an object to be polished after polishing by the aluminum oxide particles (that is, the ease of washing off of the aluminum oxide particles is improved). In this regard, when the aluminum oxide particles have an average secondary particle size of 0.01 µm or more, or more specifically 0.03 µm or more, or 0.05 µm or more, it will be easier to improve the polishing rate and the ease of washing off to a particularly suitable level for practical use.

Furthermore, the aluminum oxide particles preferably have an average secondary particle size of 2 µm or less, more preferably 1 µm or less, and further preferably 0.5 µm or less. The number of scratches and the surface roughness of an object to be polished after polishing with aluminum oxide particles decrease with the decrease in the average secondary particle size of the aluminum oxide particles. In this regard, when the aluminum oxide particles have an average secondary particle size of 2 µm or less, or more specifically 1 µm or less, or 0.5 µm or less, it will be easier to reduce the number of scratches and the surface roughness to a particularly suitable level for practical use.

### With respect to the particle size distribution

The value obtained by dividing the 90% particle size (D90) of the aluminum oxide particles by the 10% particle size (D10) of the aluminum oxide particles, D90/D10, is preferably 3 or less, more preferably 2.5 or less, further preferably 2.2 or less, and particularly preferably 2.0 or less. Here, the 90% particle size is equal to the particle size of the aluminum oxide particle that is lastly summed up when the volume of the aluminum oxide particles is accumulated from particles of the smallest size in ascending order of the particle size measured by a laser scattering method until the accumulated volume reaches 90% or more of the total volume of all the aluminum oxide particles; and the 10% particle size is equal to the particle size of the aluminum oxide particle that is lastly summed up when the volume of the aluminum oxide particles is accumulated from particles of the smallest size in ascending order of the particle size measured by a laser scattering method until the accumulated volume reaches 10% or more of the total volume of all the aluminum oxide particles. Since the proportion of coarse particles contained in the aluminum oxide particles, which may cause the increase in the number of scratches and the surface roughness, decreases as the value D90/D10 of the aluminum oxide particles decreases, the number of scratches and the surface roughness of an object to be polished decrease after polishing with aluminum oxide particles. Furthermore, since the proportion of fine particles contained in the aluminum oxide particles, which may cause reduction in the ease of washing off, also decreases as the value D90/D10 decreases, it will be easier to remove, by cleaning, the aluminum oxide particles adhering to the surface of an object to be polished after polishing. In this regard, when the aluminum oxide particles have a value D90/D10 of 3 or less, or more specifically 2.5 or less, 2.2 or less, or 2.0 or less, it will be easier to reduce the number of scratches and the surface roughness to a particularly suitable level for practical use and to improve the ease of washing off to a particularly suitable level for practical use.

The lower limit of the value D90/D10 is not particularly limited, but preferably 1.1 or more, more preferably 1.2 or more, and particularly preferably 1.3 or more.

### With respect to the alpha conversion rate

The aluminum oxide particles may have any crystalline form, and may mainly include, for example, any of a hydrated alumina such as boehmite; a transition alumina such as γ-alumina, δ-alumina, and θ-alumina; and α-alumina. However, when high hardness is required, the aluminum oxide particles preferably contain at least a certain amount of α-alumina. The alpha conversion rate of the aluminum oxide particles is preferably 5% or more, more preferably 10% or more, and further preferably 20% or more. Here, the alpha conversion rate is a value determined by an X-ray diffraction method based on the comparison with corundum. The polishing rate of an object to be polished with the aluminum oxide particles increases with the increase in the alpha conversion rate of the aluminum oxide particles. In this regard, when the aluminum oxide particles have an alpha conversion rate of 5% or more, or more specifically 10% or more, or 20% or more, it will be easier to improve the polishing rate to a particularly suitable level for practical use.

Furthermore, the alpha conversion rate of the aluminum oxide particles is preferably 70% or less, more preferably 50% or less, and particularly preferably 30% or less. As the alpha conversion rate of the aluminum oxide particles decreases, the number of scratches and the surface roughness of an object to be polished decrease after polishing with aluminum oxide particles. In this regard, when the alpha conversion rate of the aluminum oxide particles is 70% or less, or more specifically 50% or less, or 30% or less, it will be easier to reduce the number of scratches and the surface roughness to a particularly suitable level for practical use.

Aluminum oxide particles of the present embodiment are used, for example, in the form of a slurry-like polishing composition prepared by mixing the particles with at least water. A polishing composition for polishing the surface of nickel-phosphorus plated hard disk substrates is prepared by mixing the aluminum oxide particles with water, preferably along with a polishing accelerator, more preferably along with a polishing accelerator, a cleaning accelerator, and an oxidizing agent. A polishing composition for polishing display substrates is prepared, for example, by mixing the aluminum oxide particles with water. A polishing composition for polishing the wiring of semiconductor device substrates is prepared by mixing the aluminum oxide particles with water, preferably along with a polishing accelerator and an oxidizing agent.

The content of the aluminum oxide particles in the polishing composition is preferably 0.01 % by mass or more, and more preferably 0.1 % by mass or more. The polishing rate of an object to be polished with the polishing composition increases as the content of the aluminum oxide particles increases. In this regard, when the content of the aluminum oxide particles in the polishing composition is 0.01% by mass or more, or more specifically 0.1 % by mass or more, it will be easier to increase the polishing rate to a particularly suitable level for practical use.

Furthermore, the content of the aluminum oxide particles in the polishing composition is preferably 30% by mass or less, and more preferably 15% by mass or less. The dispersibility of the aluminum oxide particles in the polishing composition is improved with the decrease in the content of the aluminum oxide particles. In this regard, when the content of the aluminum oxide particles in the polishing composition is 30% by mass or less, or more specifically 15% by mass or less, it will be easier to improve the dispersibility of the aluminum oxide particles in the polishing composition to a particularly suitable level for practical use.

The polishing accelerator is optionally added to the polishing composition for increasing the polishing rate of an object to be polished with the polishing composition. Examples of the polishing accelerator that may be added to the polishing composition include organic acids and salts thereof, inorganic acids and salts thereof, and alkali compounds (including alkali metal hydroxides, ammonia, amines, and quaternary ammonium compounds).

Specific examples of the organic acids include citric acid, maleic acid, maleic anhydride, malic acid, glycolic acid, succinic acid, itaconic acid, malonic acid, iminodiacetic acid, gluconic acid, lactic acid, mandelic acid, tartaric acid, crotonic acid, nicotinic acid, acetic acid, thiomalic acid, formic acid, oxalic acid, and carboxyethyl thiosuccinic acid. Ammonium salts, alkali metal salts, and transition metal salts (including iron salts, nickel salts, and aluminum salts) of these organic acids can also be used as a polishing accelerator.

Specific examples of the inorganic acids include hydrochloric acid, sulfuric acid, nitric acid, and phosphoric acid. Ammonium salts, alkali metal salts, and transition metal salts (including iron salts, nickel salts, and aluminum salts) of these inorganic acids can also be used as a polishing accelerator.

Specific examples of the alkali metal hydroxides include potassium hydroxide, sodium hydroxide, and lithium hydroxide.

Specific examples of the amines include monoamines such as methylamine and ethylamine, diamines such as ethylenediamine, and alkanolamines such as monoethanolamine and triethanolamine.

Specific examples of the quaternary ammonium compounds include tetraalkylammonium compounds such as tetramethylammonium compounds, tetraethylammonium compounds, and tetrapropylammonium compounds.

The polishing accelerator used in the polishing composition for polishing the surface of nickel-phosphorus plated hard disk substrates is preferably an inorganic acid salt, and particularly preferred is an inorganic aluminum salt such as aluminum nitrate, aluminum sulfate, and aluminum chloride. When the inorganic aluminum salt is used in the polishing composition, the polishing rate with the polishing composition will particularly highly increase without causing the increase in the number of scratches and the surface roughness of the substrate after polishing with the polishing composition.

The polishing accelerator used in the polishing composition for polishing the wiring of semiconductor device substrates is preferably an inorganic acid or organic acid, and particularly preferred are nitric acid, sulfuric acid, and citric acid.

The polishing accelerator used in other polishing compositions is preferably an alkali metal salt of an inorganic acid, and particularly preferred are potassium chloride, sodium chloride, potassium nitrate, sodium nitrate, potassium sulfate, and sodium sulfate. These alkali metal salts promote aggregation of the aluminum oxide particles in the polishing composition, resulting in significant increase in the polishing rate with the polishing composition.

The cleaning promoter is optionally added to the polishing composition for improving the ease of washing off of the aluminum oxide particles. Any chelate compound can be used as the cleaning promoter. Specific examples of the cleaning promoter include diethylenetriamine pentaacetic acid, hydroxyethyl ethylenediamine triacetic acid, triethylenetetramine hexaacetic acid, glutamic diacetic acid, and alkali metal salts and ammonium salts of these acids.

The oxidizing agent is optionally added to the polishing composition for increasing the polishing rate of an object to be polished with the polishing composition. Any substance having an oxidative effect can be used as the oxidizing agent, but preferably used are hydrogen peroxide, which is easy in handling, and a persulfate such as ammonium persulfate, sodium persulfate, and potassium persulfate.

Next, a method for producing the aluminum oxide particles as described above will be described.

The aluminum oxide particles mainly including α-alumina or a transition alumina can be produced by calcining raw material particles, which are composed of a hydrated alumina and include primary particles each having a hexahedral shape, in a manner that the shape of the primary particles of the raw material particles may be substantially maintained. The aluminum oxide particles mainly including α-alumina can also be produced by calcining raw material particles, which are composed of a transition alumina and include primary particles each having a hexahedral shape, in a manner that the shape of the primary particles of the raw material particles may be substantially maintained. The primary particles of the raw material particles preferably each have a contour shape close to a parallelepiped defined by two opposing squares and four rectangles or squares, or a parallelepiped defined by two opposing rhombuses and four rectangles or squares. The hydrated alumina may be any of gibbsite, bayerite, nordstrandite, and boehmite. The calcination temperature is, for example, in the range of 500 to 1250°C.

The aluminum oxide particles mainly including boehmite can be produced by subjecting a slurry containing 1 to 30% by mass of gibbsite particles or bayerite particles having an average primary particle size of 10 µm or less to hydrothermal treatment at 200°C for 4 hours in an autoclave.

The above embodiment may be modified as follows.

The aluminum oxide particles of the above embodiment may be used in the applications as fillers for resins, pigments, coating agents, cosmetics, catalysts, ceramic raw materials, and the like, in addition to the application as abrasive grains.

The polishing composition of the above embodiment may optionally also contain a surfactant. In this case, the number of scratches of an object to be polished after polishing will decrease.

The polishing composition of the above embodiment may optionally also contain a water-soluble polymer. In this case, the number of scratches of an object to be polished after polishing will decrease. Specific examples of the water-soluble polymer include polysaccharides such as hydroxyethyl cellulose, pullulan, and carrageenan, and synthetic water-soluble polymers such as polyvinyl alcohol and polyvinyl pyrrolidone.

The polishing composition of the above embodiment may be prepared by diluting a stock solution of the polishing composition with water.

Next, the present invention will be more specifically described with reference to Examples and Comparative Examples.

### (Examples 1 to 17 and Comparative Examples 1 to 6)

In Examples 1 to 17 and Comparative Examples 1 to 5, any of the aluminum compound particles represented by "A" to "P" in Table 1 was mixed with water along with aluminum nitrate enneahydrate or aluminum chloride hexahydrate (polishing accelerator), tetrasodium glutamate diacetate (cleaning promoter), and hydrogen peroxide (oxidizing agent) to prepare a polishing composition. In Comparative Example 6, aluminum nitrate enneahydrate, tetrasodium glutamate diacetate, and hydrogen peroxide were mixed with water to prepare a polishing composition. The type and the content of the aluminum compound particles and the type and the content of the polishing accelerator, which are contained in the polishing composition of each Example and Comparative Example, are as shown in the columns entitled "Type of aluminum compound particles", "Content of aluminum compound particles", "Type of polishing accelerator", and "Content of polishing accelerator" in Table 2, respectively. Furthermore, the content of glutamic diacetic acid and the content of hydrogen peroxide in the polishing composition of each Example and Comparative Example are 0.3 g/L and 13 g/L, respectively, in the case of any polishing composition.

The shape shown in the column entitled "Primary particle shape" in Table 1 is based on the observation results of the primary particle shape of the aluminum compound particles using a scanning electron microscope "S-4700" manufactured by Hitachi High-Technologies Corporation. Numerical values shown in the column entitled "Aspect ratio" in Table 1 represent the average value of the aspect ratios measured for 200 pieces of aluminum compound particles based on the observation by the scanning electron microscope "S-4700". Numerical values shown in the column entitled "Alpha conversion rate" in Table 1 represent the alpha conversion rate of the aluminum compound particles determined based on comparison with corundum using an X-ray diffractometer "Mini Flex II" manufactured by Rigaku Corporation. Numerical values shown in the column entitled "Average primary particle size" in Table 1 represent the average primary particle size of the aluminum compound particles measured based on the observation by the scanning electron microscope "S-4700". Numerical values shown in the column entitled "Average secondary particle size" in Table 1 represent the average secondary particle size of the aluminum compound particles measured using a laser diffraction/scattering particle size distribution measurement apparatus "LA-950" manufactured by Horiba, Ltd. Numerical values shown in the column entitled "D90/D10" in Table 1 represent the value D90/D10 calculated from the 90% particle size and the 10% particle size of the aluminum compound particles measured using the laser diffraction/scattering particle size distribution measurement apparatus "LA-950". Note that, in Table 1, the aluminum compound particles represented by "A" to "R" are alumina particles mainly including alumina; the aluminum compound particles represented by "S" are boehmite particles mainly including boehmite; and the aluminum compound particles represented by "T" are aluminum hydroxide particles mainly including aluminum hydroxide.

The surface of an electroless nickel-phosphorus plated substrate for a magnetic disk having a diameter of 3.5 inches (≈ 95 mm) was polished on the conditions shown in Table 3 with the polishing composition of each Example and Comparative Example. The polishing rate was determined based on the difference of the weight of the substrate before and after polishing. The results are shown in the column entitled "Polishing rate" in Table 2.

The substrate polished with the polishing composition of each Example and Comparative Example was rinsed with pure water. Subsequently, the surface of the substrate after polishing was measured for the arithmetic average roughness Ra using a "Micro XAM" manufactured by Phase Shift Technology. The results are shown in the column entitled "Arithmetic average roughness Ra" in Table 2. The surface of the substrate after polishing was also measured for the arithmetic average waviness Wa using an "Opti Flat" manufactured by Phase Shift Technology. The results are shown in the column entitled "Arithmetic average waviness Wa" in Table 2.

The substrate polished with the polishing composition of each Example and Comparative Example was rinsed with pure water, and then the number of scratches on the surface of the rinsed substrate was measured. Specifically, the number of scratches was visually measured while irradiating the surface of the substrate with the light of a surface inspection lamp "F100Z" manufactured by Funakoshi chemical Co., Ltd. The results of the evaluation are shown in the column entitled "The number of scratches" in Table 2 according to the criteria as follows: Excellent (○○○), when the number of scratches measured is less than 30; Good (○○), when it is 30 or more and less than 50; Fair (○), when it is 50 or more and less than 75; Slightly Poor (×), when it is 75 or more and less than 100; and Poor (××), when it is 100 or more.

The substrate polished with the polishing composition of each Example and Comparative Example was rinsed with pure water, and then the presence or absence of adhesion of foreign matter on the surface of the rinsed substrate was observed. Specifically, the surface was observed by visual observation under a fluorescent light and observed using a scanning electron microscope. The results of the evaluation are shown in the column entitled "Adhesion of foreign matter" in Table 2 according to the criteria as follows: Excellent (○), when adhesion of foreign matter was not verified by visual observation or by a scanning electron microscope; Slightly poor (x), when adhesion of foreign matter was not verified by visual observation, but adhesion of foreign matter was verified by a scanning electron microscope; Poor (××), when adhesion of foreign matter was verified by visual observation only with difficulty; and Extremely poor (×××), when adhesion of foreign matter was clearly verified by visual observation.

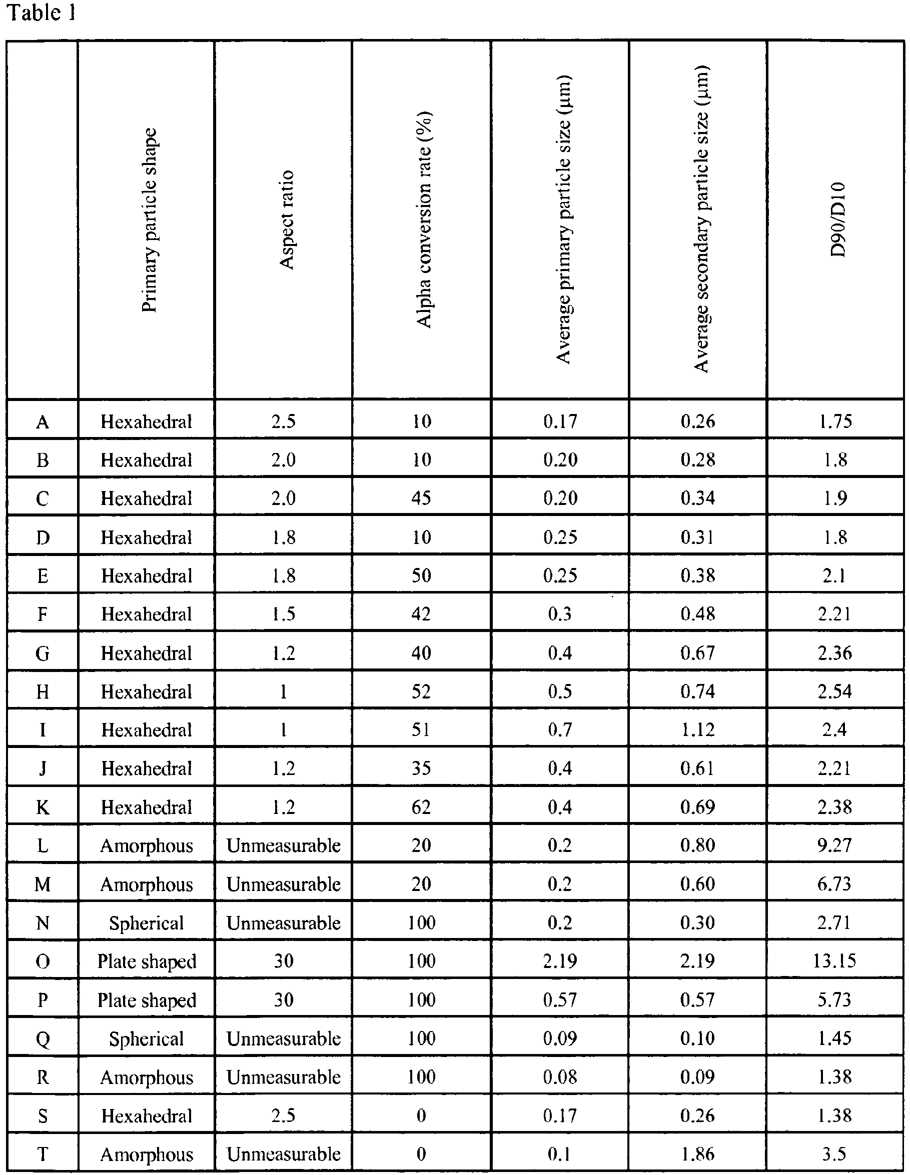

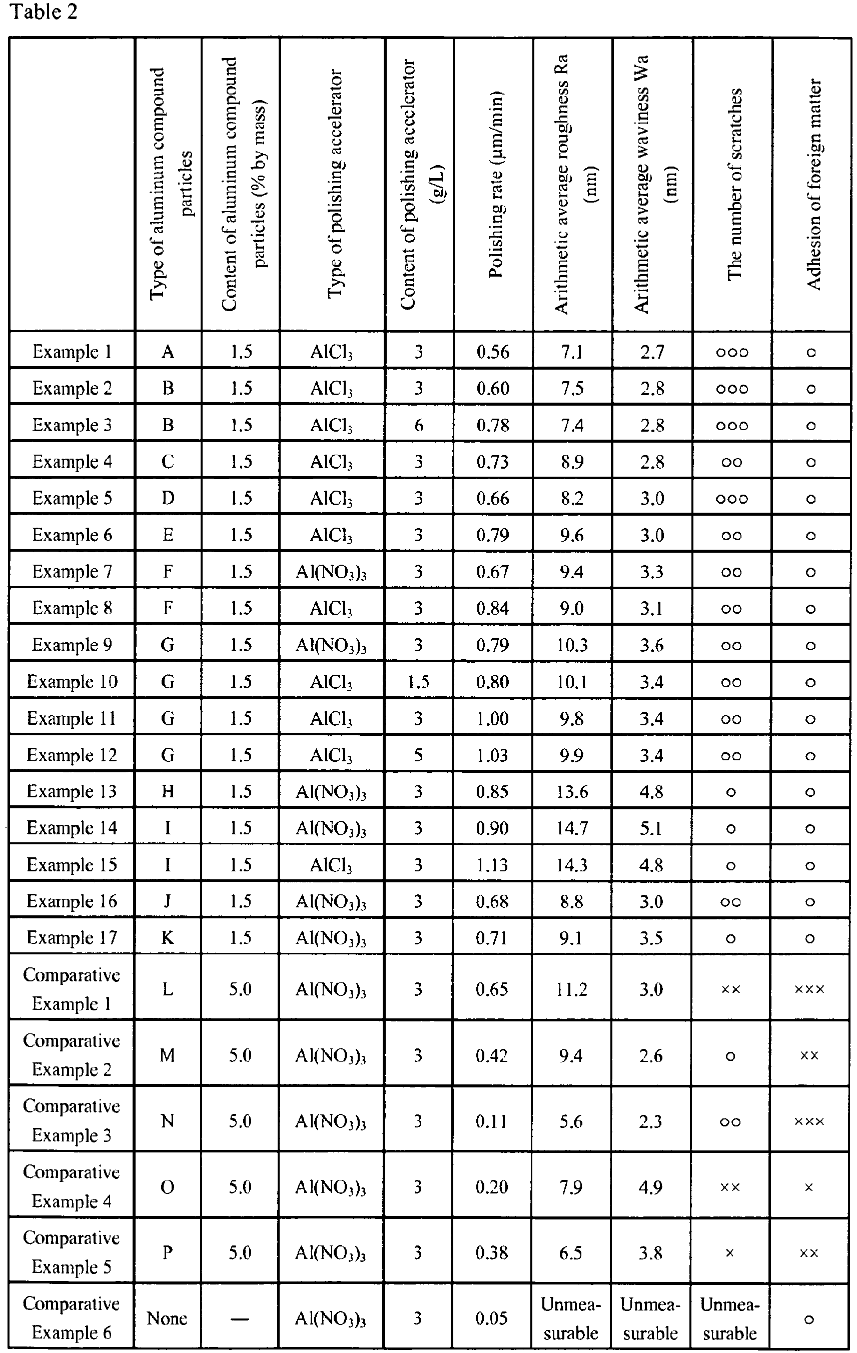

**Table 3**

| |
|---|
| Polishing machine: double-sided polishing machine ("9.5B-5P" manufactured by System Seiko Co., Ltd.) |
| Polishing pad: polyurethane pad ("CR200" manufactured by FILWEL, Co., Ltd.) |
| Polishing load: 100 g/cm² (≈ 10 kPa) |
| Rotational speed of upper platen: 24 rpm |
| Rotational speed of lower platen: 16 rpm |
| Feed rate of polishing composition: 150 mL/min |
| Polishing amount: 3 µm in thickness |

As shown in Table 2, the polishing compositions in Examples 1 to 17 provided numerical values of practically sufficient levels with respect to the polishing rate and the surface roughness (arithmetic average roughness Ra and arithmetic average waviness Wa), and also provided good results with respect to the number of scratches and adhesion of foreign matter.

### (Examples 21 to 24 and Comparative Examples 21 and 22)

Any of the aluminum compound particles represented by "A", "B", "D", "Q", "S", and "T" in Table 1 was mixed with water to prepare a polishing composition. The type and the content of the aluminum compound particles contained in the polishing composition of each Example and Comparative Example and the pH of the polishing composition of each Example and Comparative Example are as shown in Table 4.

The surface of an acrylic resin substrate for display was polished on the conditions shown in Table 5 with the polishing composition of each Example and Comparative Example. The polishing rate was determined based on the difference of the weight of the substrate before and after polishing. The results are shown in the column entitled "Polishing rate" in Table 4.

The substrate polished with the polishing composition of each Example and Comparative Example was rinsed with pure water. Subsequently, the surface of the substrate after polishing was measured for the arithmetic average roughness Ra using a "Micro XAM" manufactured by Phase Shift Technology. The results are shown in the column entitled "Arithmetic average roughness Ra" in Table 4.

The substrate polished with the polishing composition of each Example and Comparative Example was rinsed with pure water, and then the number of scratches on the surface of the rinsed substrate was measured. Specifically, the number of scratches was visually measured while irradiating the surface of the substrate with the light of a surface inspection lamp "F100Z" manufactured by Funakoshi chemical Co., Ltd. The results of the evaluation are shown in the column entitled "The number of scratches" in Table 4 according to the criteria as follows: Good (○○), when the number of scratches measured is less than 50; Fair (○), when it is 50 or more and less than 75; Slightly Poor (×), when it is 75 or more and less than 100; and Poor (××), when it is 100 or more.

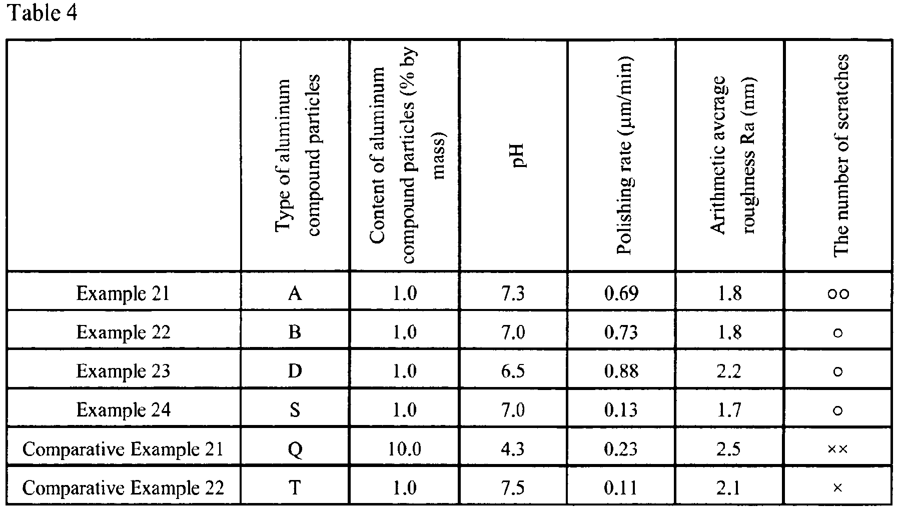

**Table 5**

| |
|---|
| Polishing machine: Oscar-type single-sided polishing machine (manufactured by Udagawa Optical Machines Co., Ltd.) |
| Polishing pad: suede pad ("SURFIN 018-3" manufactured by Fujimi Incorporated) |
| Polishing load: 80 g/cm² (≈ 8 kPa) |
| Diameter of platen: 30 cm in diameter |
| Rotational speed of platen: 130 rpm |
| Rotational speed of lower platen: 16 rpm |
| Feed rate of polishing composition: 5 mL/min |
| Polishing time: 10 minutes |

As shown in Table 4, the polishing compositions in Examples 21 to 24 provided numerical values of practically sufficient levels with respect to the polishing rate and the surface roughness (arithmetic average roughness Ra), and also provided good results with respect to the number of scratches.

### (Examples 31 and 32 and Comparative Example 31)

Either of the aluminum compound particles represented by "A" and "R" in Table 1 was mixed with water along with hydrochloric acid (polishing accelerator), potassium chloride (polishing accelerator), and hydrogen peroxide (oxidizing agent) to prepare a polishing composition. The type and the content of the aluminum compound particles contained in the polishing composition of each Example and Comparative Example and the pH of the polishing composition of each Example and Comparative Example are as shown in Table 6. Furthermore, the content of hydrochloric acid, the content of potassium chloride, and the content of hydrogen peroxide in the polishing composition of each Example and Comparative Example are 1.2 g/L, 18.8 g/L, and 34.2 g/L, respectively, in the case of any of the polishing compositions.

The surface of a semiconductor device substrate dotted with pads formed of palladium with a size of 70 µm × 70 µm was polished on the conditions shown in Table 7 with the polishing composition of each Example and Comparative Example. The polishing rate was determined based on the difference of the weight of the substrate before and after polishing. The results are shown in the column entitled "Polishing rate" in Table 6.

The substrate polished with the polishing composition of each Example and Comparative Example was rinsed with pure water, and then the number of scratches on the surface of the rinsed substrate was measured. Specifically, the number of scratches was visually measured while irradiating the surface of the substrate with the light of a surface inspection lamp "F100Z" manufactured by Funakoshi chemical Co., Ltd. The results of the evaluation are shown in the column entitled "The number of scratches" in Table 6 according to the criteria as follows: Good (○○), when the number of scratches measured is less than 50; Fair (○), when it is 50 or more and less than 75; Slightly Poor (×), when it is 75 or more and less than 100; and Poor (××), when it is 100 or more.

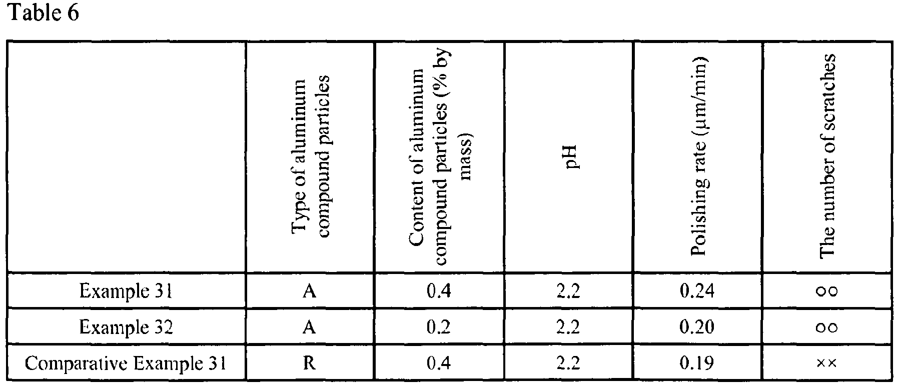

**Table 7**

| |
|---|
| Polishing machine: Westech 372M (manufactured by Equipment Acquisition Resources) |
| Polishing pad: polyurethane pad ("IC1000" manufactured by Rohm and Haas Electric Materials CMP Holdings Inc.) |
| Rotational speed of upper platen: 72 rpm |
| Rotational speed of lower platen: 69 rpm |
| Feed rate of polishing composition: 200 mL/min |
| Polishing time: 30 seconds |

As shown in Table 6, the polishing compositions in Examples 31 and 32 provided numerical values of practically sufficient levels with respect to the polishing rate and also provided good results with respect to the number of scratches.

## Claims

1. Aluminum oxide particles **characterized by** primary particles each having a hexahedral shape and an aspect ratio of 1 to less than 3,
wherein the aspect ratio is defined as "a" divided by "c", wherein "a" represents the length of the longest edge, and "c" represents the length of the shortest edge, among the three edges extending from one vertex of an aluminum oxide primary particle having a hexahedral shape.

2. The aluminum oxide particles according to claim 1, wherein the aluminum oxide particles have an average primary particle size of 0.01 to 0.6 µm.

3. The aluminum oxide particles according to claim 1 or 2, wherein the aluminum oxide particles have an alpha conversion rate of 5 to 70 %.

4. The aluminum oxide particles according to any one of claims 1 to 3, wherein the aluminum oxide particles have an average secondary particle size of 0.01 to 2 µm, and the value obtained by dividing a 90 % particle size of the aluminum oxide particles by a 10 % particle size of the aluminum oxide particles is 3 or less.

5. The aluminum oxide particles according to any one of claims 1 to 4, wherein the aluminum oxide particles are used as abrasive grains in an application of polishing a substrate used in an electronic component.

6. The aluminum oxide particles according to any one of claims 1 to 4, wherein the aluminum oxide particles are used as abrasive grains in an application of polishing a surface of a nickel-phosphorus plated object to be polished.

7. The aluminum oxide particles according to any one of claims 1 to 4, wherein the aluminum oxide particles are used as abrasive grains in an application of polishing a polishing composition formed of noble metal.

8. The aluminum oxide particles according to any one of claims 1 to 4, wherein the aluminum oxide particles are used as abrasive grains in an application of polishing an object to be polished formed of resin.

9. A polishing composition **characterized by** containing the aluminum oxide particles according to any one of claims 1 to 4 and water.

## Patentansprüche

1. Aluminiumoxid-Partikel **gekennzeichnet durch** Primärpartikel, die jeweils eine hexaedrische Form und ein Seitenverhältnis von 1 zu 3 aufweisen,
wobei das Seitenverhältnis definiert ist durch "a" geteilt durch "c", wobei "a" die Länge der längsten Kante und "c" die Länge der kürzesten Kante unter den drei Kanten, die von einer Ecke eines Aluminiumoxid-Primärpartikels mit hexaedrischer Form ausgehen, darstellt.

2. Aluminiumoxid-Partikel gemäß Anspruch 1, wobei die Aluminiumoxid-Partikel eine durchschnittliche Primärpartikelgröße von 0,01 bis 0,6 µm aufweisen.

3. Aluminiumoxid-Partikel gemäß Anspruch 1 oder 2, wobei die Aluminiumoxid-Partikel eine Alpha-Konversionsrate von 5 bis 70 % aufweisen.

4. Aluminiumoxid-Partikel gemäß einem der Ansprüche 1 bis 3, wobei die Aluminiumoxid-Partikel eine durchschnittliche Sekundärpartikelgröße von 0,01 bis 2 µm aufweisen, und der Wert, der durch Dividieren einer 90 % Partikelgröße der Aluminiumoxid-Partikel durch eine 10 % Partikelgröße der Aluminiumoxid-Partikel erhalten wird, 3 oder weniger ist.

5. Aluminiumoxid-Partikel gemäß einem der Ansprüche 1 bis 4, wobei die Aluminiumoxid-Partikel als Schleifpartikel verwendet werden in einer Anwendung, bei der ein Substrat, das in einer elektronischen Komponente verwendet wird, poliert wird.

6. Aluminiumoxid-Partikel gemäß einem der Ansprüche 1 bis 4, wobei die Aluminiumoxid-Partikel als Schleifpartikel verwendet werden in einer Anwendung, bei der eine Oberfläche eines mit Nickel-Phosphor beschichteten zu polierenden Objekts poliert wird.

7. Aluminiumoxid-Partikel gemäß einem der Ansprüche 1 bis 4, wobei die Aluminiumoxid-Partikel als Schleifkörner in einer Anwendung verwendet werden, bei der ein zu polierendes Objekt, das aus Edelmetall geformt ist, poliert wird.

8. Aluminiumoxid-Partikel gemäß einem der Ansprüche 1 bis 4, wobei die Aluminiumoxid-Partikel als Schleifpartikel in einer Anwendung verwendet werden, bei der ein zu polierendes Objekt aus Quarz poliert wird.

9. Eine Polierzusammensetzung **dadurch gekennzeichnet, dass** die Aluminiumoxid-Partikel gemäß einem der Ansprüche 1 bis 4 und Wasser enthalten sind.

## Revendications

1. Particules d'oxyde d'aluminium **caractérisées par** des particules primaires ayant chacune une forme hexahédrale et un rapport d'aspect de 1 à moins de 3,
sachant que le rapport d'aspect est défini comme « a » divisé par « c », où « a » représente la longueur du côté le plus long, et « c » représente la longueur du côté le plus court, parmi les trois côtés s'étendant depuis un sommet d'une particule primaire d'oxyde d'aluminium ayant une forme hexahédrale.

2. Les particules d'oxyde d'aluminium selon la revendication 1, sachant que les particules d'oxyde d'aluminium ont une taille de particule primaire moyenne de 0,01 à 0,6 µm.

3. Les particules d'oxyde d'aluminium selon la revendication 1 ou 2, sachant que les particules d'oxyde d'aluminium ont un taux de conversion alpha de 5 à 70 %.

4. Les particules d'oxyde d'aluminium selon l'une quelconque des revendications 1 à 3, sachant que les particules d'oxyde d'aluminium ont une taille de particule secondaire moyenne de 0,01 à 2 µm, et la valeur obtenue en divisant une taille de particule de 90 % des particules d'oxyde d'aluminium par une taille de particule de 10 % des particules d'oxyde d'aluminium est 3 ou moins.

5. Les particules d'oxyde d'aluminium selon l'une quelconque des revendications 1 à 4, sachant que les particules d'oxyde d'aluminium sont utilisées comme grains abrasifs dans une application de polissage d'un substrat utilisé dans un composant électronique.

6. Les particules d'oxyde d'aluminium selon l'une quelconque des revendications 1 à 4, sachant que les particules d'oxyde d'aluminium sont utilisées comme grains abrasifs dans une application de polissage d'une surface d'un objet plaqué de nickel phosphoreux à polir.

7. Les particules d'oxyde d'aluminium selon l'une quelconque des revendications 1 à 4, sachant que les particules d'oxyde d'aluminium sont utilisées comme grains abrasifs dans une application de polissage d'une composition de polissage constituée de métal noble.

8. Les particules d'oxyde d'aluminium selon l'une quelconque des revendications 1 à 4, sachant que les particules d'oxyde d'aluminium sont utilisées comme grains abrasifs dans une application de polissage d'un objet à polir constitué de résine.

9. Composition de polissage **caractérisée en ce qu'**elle contient les particules d'oxyde d'aluminium selon l'une quelconque des revendications 1 à 4 et de l'eau.
